# EUROPÄISCHE PATENTANMELDUNG

(11) **EP 1 624 531 A1**
(43) Veröffentlichungstag der Anmeldung: **08.02.2006**
(21) Anmeldenummer: 05013182.0
(22) Anmeldetag: 18.06.2005
(51) Int. Cl.: H01R 12/04

(54) **Einpressverbinder**

(30) Priorität: 07.08.2004 DE 202004012466 U
(71) Anmelder: ELCO Europe GmbH, D-57518 Betzdorf (DE)
(72) Erfinder: Maag, Arnulf, 57555 Mudersbach (DE); Fries, Helmut, 57520 Niederdreisbach (DE)
(74) Vertreter: Valentin, Ekkehard

(57) **Zusammenfassung**

Bei einem Einpreßverbinder (1) zum elektrisch leitfähigen Verbinden von Leiterplatten (2 a, 2 b, 2 c) über jeweils in diesen vorgesehenen durchkontaktierten Löchern (12, 13, 14), sind an dem Einpreßverbinder (1) mindestens zwei mit Abstand übereinanderliegende Einpreßzonen (6a bis 6c) vorgesehen und mit voneinander gestuft abweichenden Querschnitten bzw. Durchmessern ausgebildet, wobei die durchkontaktierten Löcher (12, 13, 14) dem jeweiligen Querschnitt bzw. Durchmesser der zugeordneten Einpreßzone (6 a, 6 b, 6 c) angepaßt sind.

## Beschreibung

Die Erfindung betrifft einen Einpreßverbinder zum elektrisch leitfähigen Verbinden von Leiterplatten über jeweils in diesen vorgesehenen durchkontaktierten Löchern.

Im Stand der Technik sind Einpreßverbinder bzw. Einpresskontakte in den verschiedensten Ausführungsformen bekannt - beispielsweise solche, die in ihrem mittleren Schaftteil eine Schlitzöffnung aufweisen - und dienen zur Herstellung lötfreier elektrischer Verbindungen, die der DIN 41611 entsprechen.

Bei diesen gattungsgemäßen Einpresskontakten bzw. -verbindern ist der eigentliche Einpressbereich, der von einem Schaftteil eines Einpressstiftes bereitgestellt wird, aufgrund der Schlitzöffnung elastisch ausgebildet, so dass die für die Einpressverbindung notwendigen Kräfte durch Verformung des elastischen Schaftteils bzw. des Einpressbereiches in der den Einpresskontakt aufnehmenden, in einer Durchgangsbohrung der Leiterplatte angeordneten Hülse aufgebracht werden.

Zum elektrisch leitfähigen Verbinden von Leiterplatten kommen sogenannte Doppel-Einpreßverbinder zum Einsatz, bei denen ober- und unterhalb eines Abstandshalters jeweils eine Einpresszone vorgesehen ist. Es wird hierbei die eine Leiterplatte mit ihrem durchkontaktierten Loch von oben auf die in Bezug auf den Abstandshalter obere Einpresszone und die andere Leiterplatte mit ihrem durchkontaktierten Loch von unten auf die in Bezug auf den Abstandshalter untere Einpresszone gepresst.

Nachteilig ist bei diesen Doppelverbindern, dass sich lediglich zwei Leiterplatten mit einem durch den Abstandshalter vorgegebenen Abstand miteinander verbinden lassen.

Der Erfindung liegt daher die Aufgabe zugrunde, einen gattungsgemäßen Einpreßverbinder ohne die eingangs genannten Nachteile und mit insbesondere größerer Einsatzmöglichkeit zu schaffen.

Diese Aufgabe wird erfindungsgemäß dadurch gelöst, dass an den Einpreßverbindern mindestens zwei mit Abstand übereinanderliegende Einpresszonen vorgesehen und mit voneinander abweichenden Querschnitten bzw. Durchmessern ausgebildet sind, wobei die durchkontaktierten Löcher dem jeweiligen Querschnitt bzw. Durchmesser der zugeordneten Einpreßzone angepaßt sind. Auf diese Weise können mehrere Leiterplatten, die komplementär zu den entsprechend unterschiedlich dimensionierten Einpresszonen abgestufte Lochungen aufweisen, mit einer je nach Bedarf definierten Distanz zueinander auf dem Einpreßverbinder etagenförmig, vorgegeben von den abgestuften Durchmessern der Einpresszonen, in ihrer Positionsreihenfolge festgelegt werden. Hiermit wird vorteilhaft erreicht, dass ein einstückiger Einpreßverbinder alle Bauteile bzw. Leiterplatten elektrisch leitend kontaktiert, womit die ansonsten hohen Übergangswiderstände zwischen den Leiterplatten verringert werden.

Eine bevorzugte Ausgestaltung der Erfindung sieht vor, dass die Querschnitte bzw. Durchmesser der einzelnen Einpresszonen vom elektrischen Anschlußende des Einpreßverbinders weg abnehmen. Der Querschnitt bzw. der Durchmesser der Einpresszonen wird stufenartig von einem Leiterplatten-Aufnahmeabschnitt zum nächsten geringer, so dass bei der Montage zuerst die Leiterplatte mit der größten Lochung über die im Durchmesser kleineren, vom elektrischen Anschlußende entfernteren Einpresszonen übergestülpt und letztlich mit der für sie vorbestimmten, den größten Durchmesser aufweisenden Einpresszone verpresst werden kann. Danach können in der gleichen Weise sukzessive die anderen Leiterplatten aufgefädelt und verpresst werden.

Eine Ausführung der Erfindung sieht vor, dass von einer mittleren Basis-Einpreßzone des Einpreßverbinders ausgehend sich sowohl zu einem oberen als auch zu einem unteren Steckanschluß hin erstreckende Einpresszonen mit jeweils von der Basis weg gestuft abnehmenden Querschnitten bzw. Durchmessern ausgebildet sind. Durch die diametral an einem einstückigen Einpreßverbinder vorgesehenen abgestuften Einpresszonen können die mit entsprechend unterschiedlichen Lochungen ausgebildete Leiterplatten in einfacher Weise beidseitig mit Abstand zueinander etagenartig auf demselben Einpreßverbinder angeordnet werden. Hierbei werden nach dem Aufpressen zunächst der Leiterplatte mit dem größten durchkontaktierten Loch auf die Basis-Einpreßzone sukzessive von oben und von unten die Leiterplatten entsprechend ihren zu den abgestuften Einpresszonen-Querschnitten komplementären Lochdurchmessern der Reihenfolge nach auf die jeweiligen Aufnahmeabschnitte gepresst.

Insgesamt wird somit für die mehreren Leiterplatten ein nur geringer Bauraum benötigt, weil minimierte, auf die Bauteile der Leiterplatten abgestimmte Abstände zwischen den abgestuften Einpresszonen direkt bei der Herstellung der Leiterplatten-Einpreßverbinder berücksichtigt werden können.

Weitere Merkmale und Einzelheiten der Erfindung ergeben sich aus den Ansprüchen und der nachfolgenden Beschreibung von in den Zeichnungen dargestellten Ausführungsbeispielen der Erfindung. Es zeigen:
- Fig. 1: einen Leiterplatten-Einpreßverbinder mit mehreren übereinander liegenden, abgestuften Einpresszonen, und darauf angeordneten, im Schnitt dargestellten Leiterplatten; und
- Fig. 2: eine andere Ausführungsform eines Leiterplatten-Einpreßverbinders mit diametral vorgesehenen, abgestuften Einpresszonen und darauf angeordneten, im Schnitt dargestellten Leiterplatten.

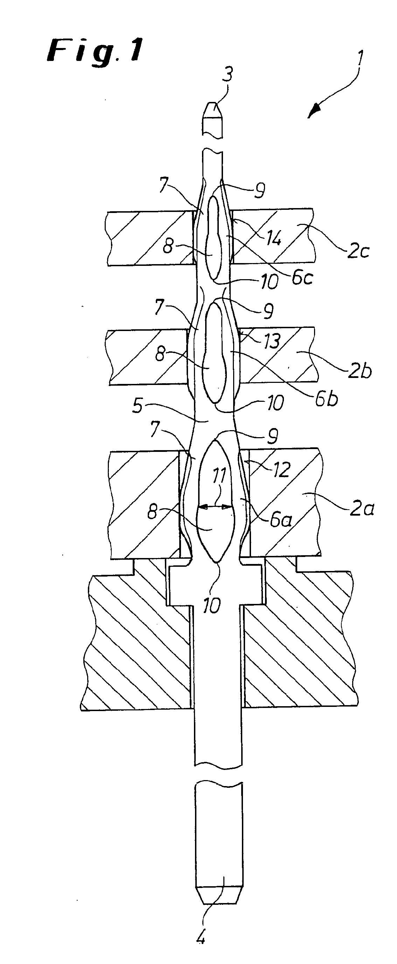

In der Fig. 1 ist ein Einpreßverbinder 1 für drei Leiterplatten 2a, 2b, 2c gezeigt, der nach oben hin mit einem Kontaktstift 3 und nach unten hin mit einer Kontaktfeder bzw. einem Steckanschluß 4 gefertigt ist. Zwischen dem Kontaktstift 3 und der Kontaktfeder 4 ist ein Aufnahmeabschnitt 5 vorgesehen, an dem aufeinanderfolgend drei Einpreßzonen 6a, 6b, 6c mit Abstand zueinander ausgebildet sind, die verschiedene Querschnitte bzw. Durchmesser aufweisen.

Die einzelnen Einpresszonen 6a, 6b, 6c weisen jeweils ein Schaftteil 7 auf, das mit einer Schlitzöffnung 8 versehen ist, deren Enden 9 und 10 eine parabolische Ausbildung haben, während ihre Mitte durch eine Einschnürung 11 gekennzeichnet ist. Durch diese Ausgestaltung der Einpresszonen 6a, 6b, 6c werden die die Schlitzöffnung 8 begrenzenden Schenkel des Schaftteils 7 elastischer, und zwar mit der Folge, dass die Einpreß- und die Auspresskraft für die Einpresszonen 6a, 6b, 6c annähernd gleich groß ist, was sie als Indikator für eine gute Kontaktgabe werden lässt.

Die Durchmesser bzw. Querschnitte der Einpresszonen 6a, 6b, 6c nehmen ausgehend von der unteren Einpresszone 6a stufenartig nach oben hin bis zur Einpresszone 6c ab. Beim Montieren der Leiterplatten 2a, 2b, 2c auf den Einpreßverbinder 1, wird zuerst die Leiterplatte 2a mit dem den größten Durchmesser ― gegenüber den Leiterplatten 2b, 2c ― aufweisenden durchkontaktierten Loch 12 über die vorgeschalteten Einpreßzonen 6c, 6b geführt und abschließend auf die Einpresszone 6a aufgepresst. Analog dazu werden dann in der Folge die Leiterplatten 2b und 2c, die zu den Außendurchmessern der Einpresszonen 6b, 6c komplementäre, durchkontaktierte Löcher 13, 14 aufweisen, auf die entsprechenden Einpresszonen 6b, 6c aufgepresst.

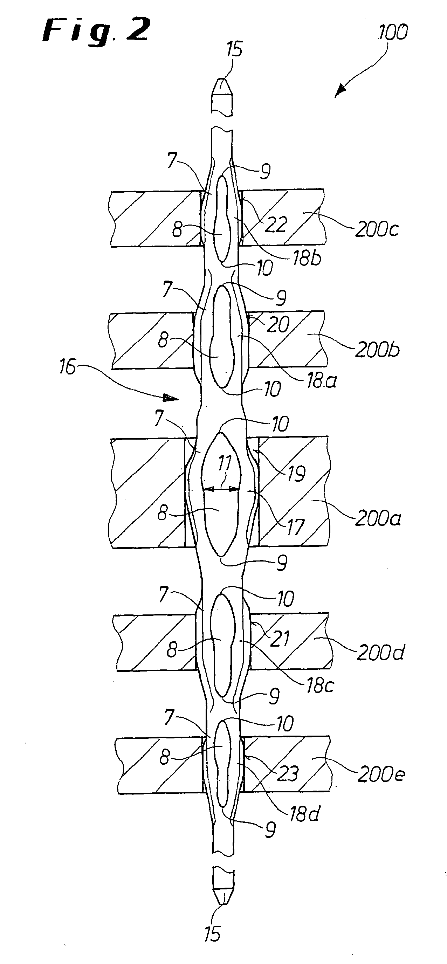

In der Fig. 2 ist ein Einpreßverbinder 100 für Leiterplatten 200a, 200b, 200c, 200d, 200e dargestellt, der im Ausführungsbeispiel sowohl nach oben als auch nach unten hin jeweils mit einem Kontaktstift 15 gefertigt ist.

Der Einpreßverbinder 100, der mit Schlitzöffnungen in seinem Schaftteil 7 wie zuvor beschrieben versehen ist, weist einen Aufnahmeabschnitt 16 auf, bei dem von einer mittleren Basis-Einpreßzone 17 ausgehend sich sowohl zum oberen als auch zum unteren Kontaktstift 15 hin erstreckende Einpresszonen 18a, 18b, 18c, 18d mit von der zentralen Basis-Einpreßzone 17 weg abnehmenden Durchmessern bzw. Querschnitten vorgesehen sind.

Zur Bestückung des Einpreßverbinders 100 mit übereinander liegenden Leiterplatten 200a bis 200e wird in einem ersten Schritt die Leiterplatte 200a mit ihrem den größten Durchmesser aufweisenden durchkontaktierten Loch 19 über die Einpresszonen 18a, 18b gestülpt und auf die Basis-Einpreßzone 17 aufgepreßt. Nachfolgend werden in weiteren Schritten sukzessive die zu den Durchmessern der jeweiligen Einpreßzonen 18a, 18c komplementäre, durchkontaktierte Löcher 20, 21 aufweisenden Leiterplatten 200b, 200d über die Einpresszonen 18b bzw. 18d gestülpt und auf die Einpresszonen 18a und 18c aufgepresst sowie abschließend die Leiterplatten 200c und 200e über ihre entsprechende Durchmesser aufweisenden Löcher 22, 23 auf die Einpresszonen 18b und 18d aufgepresst. Alternativ kann zunächst die eine oder die andere Seite bestückt werden.

## Patentansprüche

1. Einpreßverbinder (1, 100) zum elektrisch leitfähigen Verbinden von Leiterplatten (2 a, 2 b, 2 c; 200 a bis 200 e) über jeweils in diesen vorgesehenen durchkontaktierten Löchern (12, 13, 14; 19 bis 23),
**dadurch gekennzeichnet,**
**daß** an den Einpreßverbindern (1, 100) mindestens zwei mit Abstand übereinanderliegende Einpreßzonen (6a bis 6c; 17, 18a bis 18d) vorgesehen und mit voneinander gestuft abweichenden Querschnitten bzw. Durchmessern ausgebildet sind, wobei die durchkontaktierten Löcher (12, 13, 14; 19 bis 23) dem jeweiligen Querschnitt bzw. Durchmesser der zugeordneten Einpreßzone (6 a bis 6 c; 17, 18 a bis 18 d) angepaßt sind.

2. Einpreßverbinder nach Anspruch 1,
**gekennzeichnet durch**
vom elektrischen Anschlußende (4) des Einpreßverbinders (1) weg gestuft abnehmende Querschnitte/Durchmesser der einzelnen Einpresszonen (6a, 6b, 6c).

3. Einpreßverbinder nach Anspruch 1,
**dadurch gekennzeichnet,**
**daß** von einer mittleren Basis-Einpreßzone (17) des Einpreßverbinders (100) ausgehend sich sowohl zu einem oberen als auch zu einem unteren Steckanschluß (15) hin erstreckende Einpresszonen (18a, 18b, 18c, 18d) mit jeweils von der Basis weg gestuft abnehmenden Querschnitten/Durchmessern ausgebildet sind.
